Europäisches Patentamt

**European Patent Office**

**Office européen des brevets**

(11) Numéro de publication: **0 307 773 B1**

(12) **FASCICULE DE BREVET EUROPEEN**

(45) Date de publication de fascicule du brevet:
**15.01.92**

(51) Int. Cl.⁵: **H01L 23/50, G06K 19/067**

(21) Numéro de dépôt: **88114579.1**

(22) Date de dépôt: **07.09.88**

(54) **Procédé de fabrication de modules électroniques, notamment pour cartes à microcircuits.**

(30) Priorité: **14.09.87 FR 8712739**

(43) Date de publication de la demande:
**22.03.89 Bulletin 89/12**

(45) Mention de la délivrance du brevet:
**15.01.92 Bulletin 92/03**

(84) Etats contractants désignés:
**AT CH DE GB IT LI NL SE**

(56) Documents cités:
**DE-A- 3 248 385        FR-A- 2 439 438
FR-A- 2 548 857        FR-A- 2 580 416
GB-A- 2 081 974        US-A- 4 550 248**

(73) Titulaire: **EM Microelectronic-Marin SA**

**CH-2074 Marin(CH)**

(72) Inventeur: **Juan, Alain**
**Chemin des Esserts 30**
**CH-2054 Chézard(CH)**
Inventeur: **Vuilleumier, Jean-Claude**
**Planches-Vallier 5**
**CH-2088 Cressier(CH)**

(74) Mandataire: **de Raemy, Jacques et al**
**ICB Ingénieurs Conseils en Brevets SA Passage Max. Meuron 6**
**CH-2001 Neuchâtel(CH)**

# Description

La présente invention concerne un procédé de fabrication d'un module électronique, notamment pour carte à microcircuits, ce module comportant une pluralité d'électrodes destinées à entrer en contact avec un appareil dans lequel est introduite la carte, au moins une puce de circuit intégré présentant une face avant munie de bornes de connexion et une face arrière, et un ensemble de conducteurs reliant lesdites électrodes aux bornes de connexion de la puce.

Tels qu'ils sont connus actuellement, les modules électroniques destinés à équiper des cartes de transactions se présentent généralement sous la forme d'une pastille prévue pour être incorporée dans une ouverture correspondante du corps de carte située dans un coin de celle-ci et comportant une mémoire et un microprocesseur intégrés sous forme d'une seule puce ou de deux puces connectées entre elles par des conducteurs électriques, un ensemble de plages de contact, souvent au nombre de huit, reliées uniquement au microprocesseur et un corps isolant dans lequel sont noyés tous les autres éléments à l'exception naturellement des plages conductrices ou électrodes qui doivent rester accessibles pour les pièces de connexion d'un appareil, par exemple un terminal d'ordinateur, dans lequel la carte est destinée à être introduite. Dans certains cas, ce corps isolant qui définit la forme de la pastille et qui assure la protection des éléments qu'il entoure se compose d'une partie support et d'une partie couverture, dans d'autres il s'agit d'un enrobage homogène.

D'autre part, indépendamment des questions liées au circuit intégré lui-même, comme par exemple celles de savoir quelles informations la mémoire doit contenir, quelles fonctions doit remplir le microprocesseur, de quelle façon doivent être conçus cette mémoire et ce microprocesseur, la réalisation de ces modules électroniques pose un certain nombre de problèmes du fait des exigences assez nombreuses auxquelles elles doivent répondre.

Tout d'abord, une carte de paiement à microcircuits doit avoir le même format qu'une carte classique à pistes magnétiques standardisée dont la longueur est de 85 mm, la largeur de 54 mm et l'épaisseur de 0,76 mm (normes ISO) ou tout au moins des dimensions voisines pour rester peu encombrante et facilement maniable.

Si l'on se rend compte que, premièrement, une épaisseur de 760 microns ne correspond grossièrement qu'à deux fois celle d'une puce de circuit intégré sans protection, que, deuxièmement, la portion de la surface de la carte qui peut être allouée à l'unité électronique est très limitée étant donné que la majeure partie de celle-ci doit être réservée à des inscriptions telles que la dénomination du prestataire qui délivre la carte, l'identité du porteur, une signature, des informations d'utilisation et éventuellement une photo et que, troisièmement, les plages conductrices doivent être suffisamment grandes pour que le contact avec les pièces de connexion d'un appareil soit assuré et bon, on en déduit très vite que l'on ne peut pas utiliser des circuits standardisés déjà enrobés ou emboîtés comme ceux que l'on trouve actuellement sur le marché et qui sont trop volumineux.

On est donc obligé, pour fabriquer les modules électroniques, de partir de puces de circuits intégrés nues, de réaliser soi-même le réseau d'interconnexions qui permet de relier électriquement ces puces avec l'extérieur et entre elles si il y en a plusieurs dans un même module et d'assurer la protection de l'ensemble qui est naturellement très fragile surtout au niveau des jonctions entre les pièces conductrices (bornes de connexion de la puce, fils, etc).

Il faut éviter par ailleurs que des agents extérieurs, comme la lumière ou l'humidité puissent venir détériorer le circuit ou en perturber le fonctionnement.

On notera également que les cartes doivent pouvoir être fabriquées en grandes séries et à un prix de revient très bas, surtout s'il s'agit de cartes auxquelles est attribuée initialement une certaine valeur que l'on paie en les achetant et qui, lorsque cette valeur est épuisée, doivent tout simplement être jetées.

Les plages conductrices ou électrodes font également l'objet de normes quant à leurs positions sur la carte, la grandeur minimum que doivent présenter leurs surfaces et enfin les fonctions qui leurs sont attribuées. A ce sujet on consultera avec profit le projet de norme ISO n° 7816/2.2 établi par le comité technique TC 97. Dans ce document sont assignées aux huit électrodes désignées de C1 à C8 des fonctions bien précises, par exemple à l'électrode C1 la tension d'alimentation VCC, à l'électrode C3 le signal d'horloge CLK, à l'électrode C5 la masse GND et à l'électrode C7 les données d'entrée et de sortie I/O. On comprendra que cet ordre ne va pas correspondre nécessairement à celui qui a été choisi pour la puce à utiliser, de telle sorte qu'il s'agira peut-être d'envisager des détours de conducteurs reliant lesdites électrodes aux bornes de connexion de la puce. Au moins un mode de réalisation du module électronique selon la présente invention devrait permettre ces détours pour adapter une puce ayant des bornes de connexion arrangées selon un ordre quelconque, à des électrodes d'un module électronique normalisé.

Comme dans la présente invention, le module décrit dans le document DE-A-3 248 385 est composé de deux unités. La première unité comporte un premier substrat sur lequel sont imprimées des électrodes sur sa face apparente, la face opposée du substrat portant des métallisations reliées aux électrodes par des trous métallisés. La seconde unité comprend un second substrat et des conducteurs métallisés destinés à relier les bornes d'une puce aux métallisations portées par le premier substrat. Sous chacun de ces conducteurs est percé une ouverture grâce à laquelle est possible de souder le conducteur à la métallisation correspondante du premier substrat. On constate cependant que ces conducteurs recouvrent entièrement et dépassent même largement les ouvertures percées sous eux, de telle sorte qu'ils ne présentent aucune extrémité libre et mobile qui serait susceptible d'être soudée à une électrode superficielle d'un premier substrat qui serait pourvu d'un trou sous-jacent comme cela est montré par exemple dans le document FR-A-2 439 438. Contrairement à cela, et comme cela apparaîtra plus bas, la présente invention propose des conducteurs imprimés qui présentent des extrémités susceptibles d'être pliées de telle manière qu'elles puissent être introduites dans des trous donnant accès aux électrodes du module, puis soudées à ces électrodes.

Le but de l'invention est d'apporter une solution satisfaisante aux différents problèmes qui ont été évoqués ci-dessus.

Ainsi, conformément à l'invention, le procédé de fabrication du module électronique comprend comme décrit dans la revendication 1 les étapes suivantes :

- on fabrique une première unité comportant un premier substrat isolant lequel porte une pluralité d'électrodes, chaque électrode recouvrant un trou pratiqué dans ledit premier substrat,
- on fabrique une seconde unité en suivant les opérations suivantes : on se munit d'une puce de circuit intégré et d'un second substrat isolant, on enduit le second substrat de matière adhésive, on pratique dans le second substrat une ouverture rectangulaire dont les dimensions sont légèrement plus grandes que les dimensions périphériques de la puce, on perfore le second substrat d'un nombre de seconds trous correspondant au nombre des premiers trous pratiqués dans la première unité, lesdits seconds trous étant arrangés pour être sensiblement coaxiaux aux premiers quand lesdites première et seconde unités sont superposées, on applique une feuille métallique sur ladite matière adhésive, on grave chimiquement ladite feuille pour former un ensemble de conducteurs de telle façon qu'une des premières extrémités libres de chacun desdits conducteurs tombe au droit d'une borne de connexion de la puce et que chacune des secondes extrémités libres de chacun desdits conducteurs en tombe au droit d'un second trou correspondant de la seconde unité, on introduit dans ladite ouverture rectangulaire la face avant de ladite puce par le dessous du second substrat, on soude la puce sur lesdites premières extrémités libres desdits conducteurs, et on enduit de colle soit la face de la seconde unité portant les conducteurs, soit la face arrière de la première unité,

- on applique la première unité sur la seconde unité, les trous de la première étant tournés vers les conducteurs portés par la seconde,
- on introduit les secondes extrémités libres (41) des conducteurs de la seconde unité dans les trous respectifs de la première unité en les y poussant au moyen d'un outil qu'on introduit dans les trous respectifs de la seconde unité, et on soude lesdits conducteurs aux électrodes correspondantes portées par ladite première unité.

Les revendications dépendantes décrivent des variantes avantagenses de ce procédé.

Les caractéristiques et avantages de l'invention apparaîtront au cours de la description détaillée mais non limitative qui suit des deux manières possibles de la mettre en oeuvre.

Cette description sera faite en référence aux dessins annexés parmi lesquels :

La figure 1 montre, vue en plan, l'allure générale d'une carte à microcircuits composée d'un module électronique encarté dans un support,

La figure 2a montre en perspective la première unité dont est composé le module électronique, unité munie d'électrodes,

La figure 2b montre en perspective la seconde unité dont est composé le module électronique, unité munie d'une puce à microcircuits,

La figure 2c montre en coupe le module électronique assemblé, coupé selon les lignes II-II des figures 2a et 2b en supposant les deux unités superposées,

La figure 2d montre à l'échelle fortement agrandie, la zone B délimitée par le trait en pointillé de la figure 2c, les figures 2a à 2d représentant un mode de réalisation principal de l'invention,

Les figures 3a et 3b et les figures 4a, 4b et 4c montrent respectivement deux façons différentes de réaliser la première unité du module électronique,

La figure 5 montre comment est réalisée la second unité du module, unité représentée en figure 2b,

Les figures 6a et 6b montrent en vue de dessus, respectivement une première unité et une seconde unité composant un module électronique, selon un exemple pratique,

Les figures 7a, 7b et 7c montrent en perspective trois modules électroniques réalisés selon l'invention et dans lesquels les première et seconde unités présentent respectivement des surfaces et des contours égaux (figure 7a), des surfaces différentes et contours semblables (figure 7b), des surfaces différentes et des contours différents (figure 7c) et

La figure 8 est une coupe selon la ligne VIII-VIII de la figure 7b montrant comment le module électronique de la figure 7b peut être encarté dans une carte de crédit par exemple.

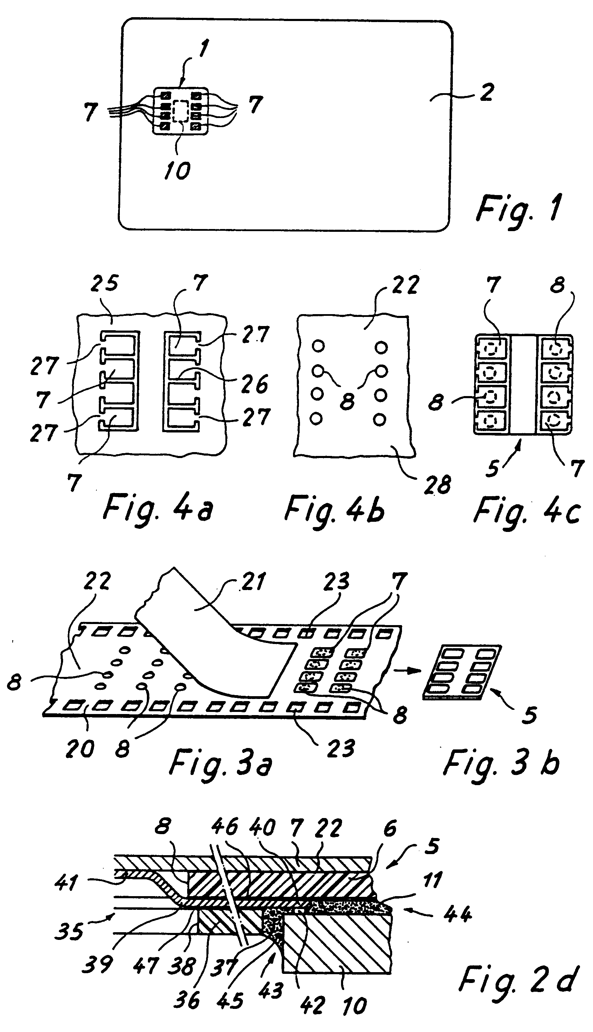

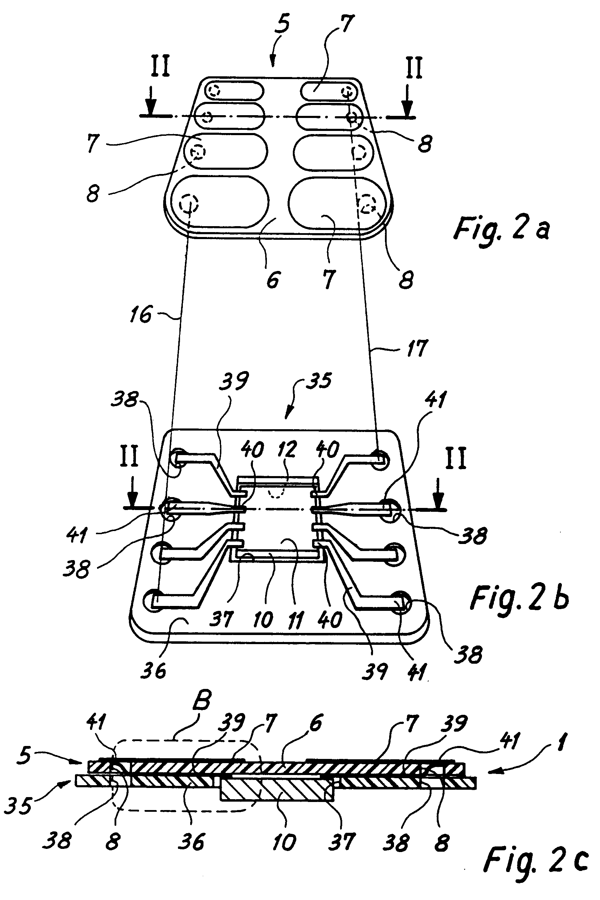

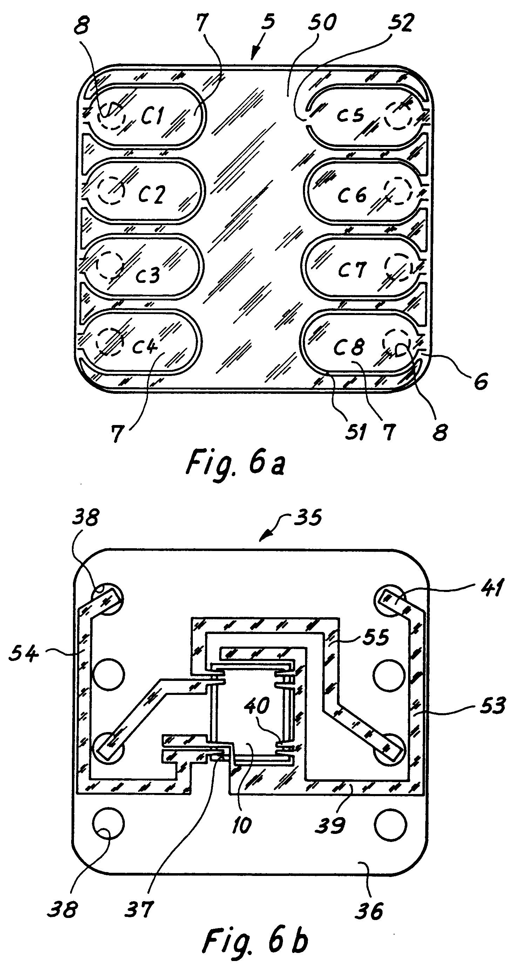

La figure 1 montre une vue en plan d'une carte à microcircuits comportant un module électronique 1 encarté dans un support 2. Comme on l'a déjà dit plus haut le support 2 est normalisé quant à ses dimensions. Le module électronique comporte généralement huit électrodes 7 dont les dimensions, les emplacements par rapport aux bords de la carte et les fonctions sont également normalisées. Chaque électrode 7 est un rectangle dont les dimensions minima sont de 2,0 x 1,7 mm. Dans les cas les plus courants, la puce à circuit intégré 10 trouve place entre les électrodes 7 et sous le substrat isolant qui porte lesdites électrodes. Les électrodes sont destinées à entrer en contact électrique avec un appareil dans lequel la carte est introduite. Un ensemble de conducteurs, non représentés à la figure 1, mais qui seront décrits plus bas relient les électrodes aux bornes de connexion de la puce.

La présente invention décrit une façon de réaliser le module électronique 1, une manière possible d'encarter le module dans le support 2 n'étant évoqué à la fin de la présente description que pour rendre cette dernière plus complète.

Selon l'invention, on commence par fabriquer une première unité telle qu'elle est représentée en perspective sur la figure 2a. Cette première unité comporte un premier substrat isolant 6 recouvert par une pluralité d'électrodes 7 dont la surface recouvre au moins l'aire normalisée discutée à propos de la figure 1. Chaque électrode 7 recouvre un premier un trou 8 pratiqué dans le premier substrat 6. Plusieurs procédés peuvent être mis en oeuvre pour la fabrication de cette première unité dont deux vont être décrits maintenant.

Une première manière de fabrication est montrée en figures 3a et 3b qui utilise un film pour fabrication en grandes séries. Ce pourrait être cependant une fabrication pièce par pièce auquel cas on aurait autant de substrats que de pièces.

On se munit d'un film présentant un substrat isolant 20, comme le montre la figure 3a, réalisée, en polyimide, en polyester ou en verre-époxy (épaisseur de l'ordre de 125 μm). On enduit le substrat 20 d'une matière adhésive 22, dont l'épaisseur peut varier entre 25 et 35 μm. On perfore ensuite le substrat ainsi revêtu d'un nombre de trous 8 correspondant au nombre d'électrodes 7 que portera la première unité 5 (voir figure 2a) une fois réalisée. On applique alors en la laminant une feuille métallique 21 (épaisseur comprise 35 et 70 μm) sur le substrat 20 qui y adhère fortement à cause de la couche de colle 22. On grave chimiquement ladite feuille selon un procédé semblable à celui qui est utilisé pour fabriquer les circuits imprimés de façon à obtenir le champ d'électrodes 7 en s'arrangeant pour que chaque électrode 7 recouvre un trou. Enfin si la première unité est réalisée sur film, comme c'est le cas de la figure 3a, on découpe ladite première unité du film 20 pour obtenir la pièce 5 montrée en figure 3b.

La figure 3a montre un film 35 mm à perforations normalisées 23. Vu les dimensions également normalisées des électrodes 7, on pourra loger deux premières unités dans la largeur du film, alors que la figure n'en montre qu'une, simplement pour bien faire apparaître le détail du procédé de fabrication.

On peut reprocher à la méthode qui vient d'être décrite son coût relativement élevé, provenant de l'usinage photolithographique. D'autre part cet usinage comporte une étape d'attaque chimique du métal par un solvant qui produit une forte pollution ionique du substrat isolant. Or, une telle pollution, que même un nettoyage approprié ne permet pas d'éliminer totalement, a pour effet de diminuer la fiabilité à long terme des unités.

Pour pallier ces inconvénients on peut mettre en oeuvre une seconde manière de fabriquer cette première unité et qui va être exposée maintenant, illustrée par les figures 4a à 4c.

Dans ce procédé, on se munit d'une feuille métallique 25. On forme les électrodes 7 par étampage ou par gravure chimique comme le montre la figure 4a, les électrodes étant séparées les unes des autres par des séparations 26, mais restant reliées à la feuille par des ponts 27 pour maintenir le tout ensemble. On se munit également d'un substrat isolant 28 qu'on enduit de matière adhésive 22 (figure 4b). On perfore ensuite le substrat ainsi recouvert d'un nombre de trous 8 correspondant au nombre d'électrodes 7 portés par la première unité 5 à la fin de sa fabrication. On applique alors la feuille 25 (figure 4a) sur le substrat 28 (figure 4b) en s'arrangeant pour que chaque électrode 7 vienne recouvrir un trou correspondant 8. Enfin on étampe l'ensemble ainsi formé en s'arrangeant pour couper les ponts 27 par la même occasion. On obtient alors la première unité 5 montrée en figure 4c.

On notera que la première unité ainsi obtenue peut également être réalisée en grandes séries sur films normalisés, de la manière décrite à propos de la figure 3b.

On fabrique ensuite une seconde unité 35 dont l'allure finale est montrée en perspective à la figure 2b. Cette seconde unité comporte un second substrat isolant 36 dans lequel est pratiqué une ouverture rectangulaire 37 dont les dimensions sont légèrement plus grande que les dimensions périphériques d'une puce à circuit intégré 10 qui prend place dans ladite ouverture 37. Le second substrat 36 est encore percé d'une pluralité de seconds trous 38 correspondant aux premiers trous 8 pratiqués dans la première unité 5, ces seconds trous étant arrangés pour être sensiblement coaxiaux aux premiers quand les première et seconde unités sont superposées. Cette coïncidence de construction est figurée au dessin par deux lignes 16 et 17. Le second substrat isolant 36 porte également une pluralité de conducteurs 39 dont les premières extrémités libres 40 de chacun de ces conducteurs tombe au droit d'une borne de connexion de la puce (non représentée sur la figure 2b) et dont chacune des secondes extrémités libres 41 tombe au droit d'un second trou 38. La puce 10 qui présente quant à celle une face avant 11 munie des bornes de connexion et une face arrière 12 qui en est dépourvue, est introduite dans l'ouverture 37 et ses bornes de connexion sont soudées aux premières extrémités libres 40 des conducteurs 39.

Une fois ces deux unités produites, on enduit de colle soit la face de la seconde unité qui porte les conducteurs, soit la face arrière de la première unité. On applique la première unité 5 sur la seconde unité 35, les trous de la première étant tournés vers les conducteurs portés par la seconde. Enfin on introduit chacun des conducteurs 39 de la seconde unité 35, par sa seconde extrémité 41, dans un trou correspondant 8 de la première unité 5 et on soude chacune de ces extrémités 41 à une électrode correspondante 7.

On obtient alors le module électronique montré en figure 2c. Cette figure fait comprendre en outre le pourquoi des seconds trous 38 par lesquels pourra être introduite l'outil de soudage des conducteurs.

L'assemblage qui vient d'être décrit apparaît plus clairement sur la figure 2d qui montre à échelle agrandie la zone B délimitée en pointillé sur la figure 2c. On y voit la première unité 5 munie de son substrat 6 et d'une électrode 7 entre lesquels est apparente une couche de colle 22. Dans le premier trou 8 pénètre la seconde extrémité 41 du conducteur 39. Cette extrémité est soudée à l'électrode 7. La première extrémité 40 du conducteur 39 est soudée sur une borne de connexion 42 de la face avant 11 de la puce 10.

La figure 2d montre en outre que l'espace libre 43 formé entre le bord périphérique de la puce 10 et l'ouverture restangulaire 37 dans laquelle cette puce est introduite, ainsi que l'espace 44 formé entre les conducteurs 39 et la face avant de la puce est rempli d'une masse résineuse 45 appliquée pour rigidifier ensemble la puce 10, le second substrat 36 et les conducteurs 39. La même figure montre aussi une couche de colle 46 extrêmement mince servant à coller la première unité 5 sur la seconde unité 35. En réalité la majorité de la colle va se trouver située entre les conducteurs 39 à un endroit non visible sur le dessin, et on donnera à ces conducteurs une forme qui obligera la colle à glisser à cet endroit au moment de l'application des deux unités l'une contre l'autre, ceci dans le but de réduire au minimum l'épaisseur prise par la colle. La figure 2d montre enfin une couche de colle 47 qui résulte de la fabrication de la seconde unité.

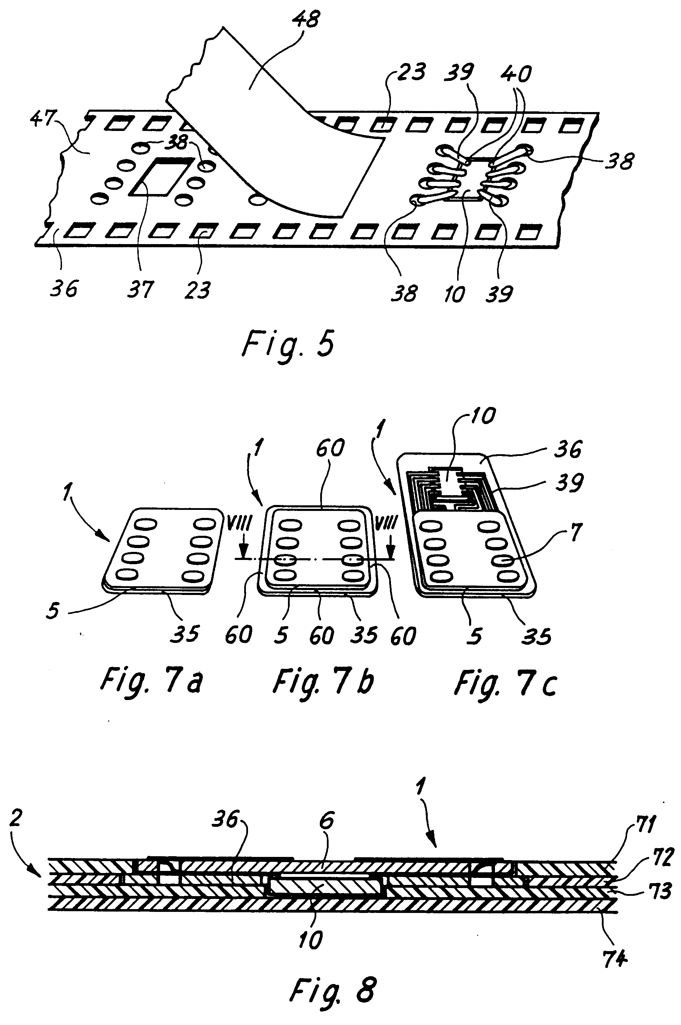

Reste encore à donner quelques détails sur la manière de confectionner la seconde unité 35 montrée en figure 2b. On se reportera pour cela à la figure 5.

On se munit du second substrat isolant 36 qui se présente ici sous la forme d'un film normalisé 35 mm. On enduit le second substrat de matière adhésive 47. On perfore le second substrat de l'ouverture rectangulaire 37 et des seconds trous 38. On applique une feuille métallique 48 sur la matière adhésive. Ensuite, et comme cela est visible sur la droite de la figure 5, on fait apparaître les conducteurs 39 par procédé photolithographique. On se munit de la puce de circuit intégré 10 et on soude les bornes de ladite puce aux premières extrémités 40 des conducteurs 39. Enfin si la seconde unité est réalisée sur film, ce qui est le cas montré en figure 5, on découpe cette seconde unité du film pour obtenir la pièce 35 montrée en figure 2b.

Le réseau de conducteurs 39 étant supporté par le second substrat isolant 36, le film de colle 47 étant interposé entre chaque conducteur et le substrat, on donne le nom de film trois couches au produit illustré en figure 2b.

La figure 5 montre un film 35 mm à perforations normalisées 23. Pour ce genre de film, il sera généralement possible de loger deux secondes unités dans la largeur de ce film, alors que la figure n'en montre qu'une, ceci simplement pour bien faire apparaître le détail du procédé de fabrication.

Les figures 6a et 6b montrent, vues de dessus, respectivement une réalisation pratique d'une première unité 5 et d'une seconde unité 35 avant leur assemblage et réalisées selon l'invention.

Les électrodes 7 de l'unité 5 sont repérées par les références C1 à C8 selon la norme ISO mentionné dans l'introduction de la présente description. Ces électrodes sont au moins égales en superficie à la surface normalisée; elles recouvrent chacune un premier trou 8. La figure 6a montre que la zone 50 située entre les électrodes, de même qu'entre les deux rangées d'électrodes est faite de même métal qui lesdites électrodes, un espace 51 sans métal étant ménagé pour isoler ces électrodes de ladite zone 50. Cette zone 50 est reliée électriquement à l'électrode C5 par un isthme 52. Cela est intentionnellement recherché puisque l'électrode C5 représente la masse (GND) de la puce qui, par cet isthme, réalise un blindage pour la puce.

La seconde unité 35 montrée en figure 6b présente un découpage extérieur identique au découpage extérieur de la première unité 5. Une fois superposées, les deux unités ne présentent qu'un seul bord (voir aussi figure 7a). La seconde unité 35 est équipée d'une puce 10 dont les fonctions des bornes de sortie ne sont pas ordonnées de la même façon que celles des électrodes normalisées du module. On est donc obligé d'opérer certains détours de conducteurs 39, détours qui sont visibles sur la figure 6b (par exemple conducteurs 53, 54, et 55). L'invention présente l'avantage de permettre ces détours grâce auxquels on peut utiliser une puce dont les bornes sont arrangées de façon quelconque pour équiper un module électronique dont les électrodes sont normalisées.

Les figures 7a, 7b et 7c montrent en perspective trois modules électroniques terminés réalisés selon l'invention.

Le module électronique 1 de la figure 7a est composé de la première unité 5 et de la seconde unité 35. Bien que cela ne soit pas visible au dessin, la puce de l'unité 35 est disposée entre deux rangées de seconds trous (comme cela est visible en figure 2c). La figure 7a montre qu'une fois superposées, les unités 5 et 35 se trouvent bord à bord, ce qui implique que les première et seconde unités ont mêmes surfaces et mêmes contours. Dans ce cas on ménagera un logement de même forme et de même épaisseur que le module dans la carte à microcircuit et on collera le module dans la carte de la même manière qu'un timbre sur une lettre.

On peut craindre cependant que le module se détache trop facilement de la carte s'il est encarté comme proposé ci-dessus. On produira alors un module réalisé selon la figure 7b, la seule différence d'avec le premier module consistant à avoir, pour la première unité 5, une surface plus petite que pour la seconde unité 35, le contour des deux unités étant semblable, de sorte que le contour de la première unité est un retrait du contour de la seconde, le module présentant un escalier périphérique 60. La figure 8 montre comment un tel module peut être encarté dans une carte si on établit une coupe selon la ligne VIII-VIII dans la figure 7b. On retrouve ici le module 1 de la figure 2c avec ses première et seconde unités. La figure 8 montre que la carte 2 est constituée d'une superposition de couches pressées ensemble et référencées 71,72,73 et 74. La couche 71 entoure la première unité et son substrat isolant 6 et la couche 72 entoure le substrat isolant 36 de la seconde unité. La couche 73 s'étend jusqu'à la périphérie de la puce 10, tandis que la couche 74 forme couche de fermeture. Une fois les couches pressées ensemble, on voit que le module 1 est solidement ancré dans la carte puisque l'escalier 60 empêche tout sortie intempestive du module . On comprendra ici pourquoi la couche de colle 46 (voir figure 2d), disposée entre les deux unités, est nécessaire. Sans elle le substrat 6, sollicité mécaniquement, pourrait se détacher de la seconde unité.

On a admis jusqu'ici que la puce pouvait prendre place entre les deux rangées de trous portées par la seconde unité. Il peut arriver cependant que cette puce soit assez grande pour ne pas pouvoir être logée dans l'espace compris entre ces rangées. Dans ce cas on fabriquera un module tel qu'il est montré en figure 7c. Ici la puce est disposée en dehors de l'espace compris entre les deux rangées sur un substrat 36 qui déborde sur un côté le contour de la première unité 5 de telle façon que la puce se trouve en dehors du champ couvert par cette première unité. Les liaisons électriques entre la puce et les électrodes 7 de la première unité 5 sont réalisés comme décrit plus haut par des conducteurs 39 et les deux unités 5 et 35 sont fabriquées selon les mêmes procédés que ceux qui ont été exposés ci-dessus. On remarquera que la disposition de la figure 7c permettrait d'avoir, en plus de la puce 10, une puce de dimensions normales qui serait disposée entre les rangées de trous. La seconde unité 35 contiendrait alors des conducteurs supplémentaires pour lier électriquement les deux puces ensemble.

Certaines des figures accompagnant la présente description font état de fabrication en grandes séries faite à partir de films. Le film, généralement du 35 mm perforé de façon standard, est utilisé pour mettre en oeuvre un systéme bien connu, le TAB (tape automated bonding) qui sera mis utilement à profit dans la présente invention pour réaliser les première et seconde unités nécessaires à la confection du module électronique de l'invention.

On mentionnera pour terminer que les première et seconde unités sont fabriquées séparément sur leurs supports respectifs. Au lieu de détacher chacune des unités de son support juste avant l'assemblage, on pourrait ne détacher que la première unité de son support qu'on vient assembler ensuite sur une seconde unité qui elle, reste attachée à son support. Les modules sont alors livrés en bandes à l'encarteur qui se charge de les découper et de les monter dans les cartes. Cette façon de faire est élégante, rapide pour le travail d'encartage et ne nécessite pas de précautions spéciales, le module étant bien protégé de lui-même comme il ressort de la présente description.

De toute façon, que les modules soit livrés pièce par pièce ou montés sur film, ils constitueront une unité standard pour l'encarteur qui n'aura plus à se soucier des désirs particuliers présentés par les clients, ces désirs ayant déjà été satisfaits par le fabricant du module électronique.

On notera que la première unité 5 ne comporte aucun perçage pour le passage de la puce et qu'en cela cette unité sert de protection vers l'extérieur de ladite puce. On notera aussi que les conducteurs 39 sont situés sur la face avant de la seconde unité 35 et sont en contact avec la face arrière de la première unité, ce qui est important pour obtenir une épaisseur réduite du module, d'une part, et pour faciliter la fabrication de la seconde unité, d'autre part.

On notera enfin que les figures présentées ici en exemple font état de trous ronds pour le passage des conducteurs. Ces trous pourraient avoir une autre forme, rectangulaire par exemple.

## Revendications

1. Procédé de fabrication d'un module électronique (1) d'une carte à microcircuits (2), ce module comportant une pluralité d'électrodes (7) destinées à entrer en contact avec un appareil dans lequel est introduite la carte, au moins une puce de circuit intégré (10) présentant une face avant (11) munie de bornes de connexion (42) et une face arrière (12), et un ensemble de conducteurs relient lesdites électrodes aux bornes de connexion de la puce , comprenant les étapes suivantes :

   - on fabrique une première unité (5) comportant un premier substrat isolant (6,20,28) lequel porte la pluralité d'électrodes (7), chaque électrode recouvrant un trou pratiqué dans ledit premier substrat,
   - on fabrique une seconde unité (35) en suivant les opérations suivantes : on se munit de la puce de circuit intégré et d'un second substrat isolant (36), on enduit le second substrat de matière adhésive (47), on pratique dans le second substrat une ouverture rectangulaire (37) dont les dimensions sont légèrement plus grandes que les dimensions périphériques de la puce, on perfore le second substrat d'un nombre de seconds trous (38) correspondant au nombre des premiers trous (8) pratiqués dans la première unité, lesdits seconds trous étant arrangés pour être sensiblement coaxiaux aux premiers quand lesdites première et seconde unités sont superposées, on applique une feuille métallique (48) sur ladite matière adhésive (47), on grave chimiquement ladite feuille pour former l'ensemble de conducteurs (39) de telle façon qu'une des premières extrémités libres (40) de chacun desdits conducteurs tombe au droit d'une des bornes de connexion (42) de la puce et que chacune des secondes extrémités libres (41) de chacun desdits conducteurs tombe au droit d'un second trou (38) correspondant de la seconde unité on introduit dans ladite ouverture rectangulaire la face avant (11) de ladite puce par le dessous du second substrat, on soude la puce sur lesdites premières extrémités libres desdits conducteurs et on enduit de colle soit la face de la deuxième unité portant les conducteurs, soit la face arrière de la première unité,
   - on applique la première unité (5) sur la seconde unité (35), les trous de la première étant tournés vers les conducteurs portés par la seconde,
   - on introduit les secondes extrémités libres (41) des conducteurs de la seconde unité dans les trous respectifs (8) de la première unité en les y poussant au moyen d'un outil qu'on introduit dans les trous respectifs (38) de la seconde unité, et on soude lesdites extrémités aux électrodes correspondantes portées par ladite première unité.

2. Procédé selon la revendication 1, caractérisé par le fait que la première unité (5) est fabriquée en suivant les opérations suivantes : on se munit du premier substrat isolant (6,20), on enduit le premier substrat d'une matière adhésive, on perfore le premier substrat d'un nombre de trous (8) correspondant au nombre d'électrodes (7) portées par ladite première unité à la fin de sa fabrication, on applique une feuille métallique (21) sur ladite matière adhésive et on grave chimiquement lesdites électrodes, ces dernières venant recouvrir chacune un desdits trous.

3. Procédé selon la revendication 1, caractérisé par le fait que la première unité est fabriquée en suivant les opérations suivantes : on se munit du premier substrat isolant (28), on enduit le premier substrat d'une matière adhésive (22), on perfore le premier substrat d'un nombre de trous (8) correspondant au nombre d'électrodes (7) portées par ladite première unité à la fin de sa fabrication, on se munit d'une feuille métallique (25), on forme les électrodes par étampage ou par gravage chimique, chacune desdites électrodes restant reliée à la feuille par un pont (27) pour maintenir le tout ensemble, on applique la feuille sur ladite matière adhésive recouvrant ledit premier substrat, les électrodes venant recouvrir chacune un desdits trous et on étampe l'ensemble ainsi formé en coupant en même temps lesdits ponts pour obtenir ainsi ladite première unité,

4. Procédé selon la revendication 1, caractérisé par le fait qu'au moins un espace libre (43) formé entre le bord périphérique de la puce (10) et l'ouverture rectangulaire (37) dans laquelle elle est introduite, ainsi qu'entre les conducteurs (39) et la face avant (11) de la puce est rempli d'une masse (45) pour rigidifier ensemble la puce, le second substrat et les conducteurs.

5. Procédé selon la revendication 1, caractérisé par le fait que les première et seconde unités sont fabriquées en grandes séries sur films (20,28,36) et qu'une fois réalisées elles sont découpées de leurs films respectifs.

6. Procédé selon la revendication 1, caractérisé par le fait que les première et seconde unités sont fabriquées en grandes séries sur films (20,28,36) et qu'une fois réalisée,la première unité (5) est découpée de son film, puis appliquée sur la seconde unité (35), cette dernière restant attachée à son film (36), le produit fini étant livré en bandes.

7. Procédé selon la revendication 1, caractérisé par le fait que lesdits seconds trous (38) sont disposés en deux rangées parallèles, ladite puce (10) étant disposée dans l'espace compris entre lesdites rangées.

8. Procédé selon la revendication 7, caractérisé par le fait que la première unité (5) présente une surface et un contour égaux à la surface et au contour de la seconde unité (35) de manière à ce que , une fois superposées, lesdites unités se trouvent bords à bords.

9. Procédé selon la revendication 7, caractérisé par le fait que les première (5) et seconde (35) unités présentent un contour semblable, la surface de la première étant plus petite que la surface de la seconde de manière à ce que, une fois superposée la première unité sur la seconde unité, le contour de la première se trouve en retrait du contour de la seconde.

10. Procédé selon la revendication 1, caractérisé par le fait que lesdits seconds trous (8) sont disposés en deux rangées parallèles, ladite puce (10) étant disposée en dehors de l'espace compris entre lesdites rangées.

11. Procédé selon la revendication 10, caractérisé par le fait que la surface de la première unité (5) est plus petite que la surface de la seconde unité (35) de manière à ce que, une fois lesdites unités superposées, le contour de la première soit en retrait du contour de la seconde, la puce n'étant pas couverte par ladite première unité.

## Claims

1. Method of manufacture of an electronic module (1) of a card provided with microcircuits (2), such module including a plurality of electrodes (7) intended to come into contact with an apparatus into which the card is introduced, at least one integrated circuit chip (10) exhibiting a front face (11) provided with connection terminals (42) and a back face (12) and a set of conductors coupling said electrodes to the connection terminals of the chip, comprising the following steps :

   - fabricating a first unit (5) including a first insulating substrate (6, 20, 28) bearing the plurality of electrodes (7), each electrode overlaying a hole provided in said first substrate;

   - fabricating a second unit (35) by the successive operations of : obtaining the integrated circuit chip and a second insulating substrate (36), coating the second substrate with adhesive material (47), forming a rectangular opening (37) in the second substrate of dimensions slightly greater than the peripheral dimensions of the chip, perforating the second substrate with second holes (38) corresponding in number to the first mentioned holes (8) provided in the first unit, said second holes being arranged to be substantially coaxial to the first holes when said first and second units are superposed, applying a metallic leaf (48) onto said adhesive material (47), chemically engraving said leaf so as to form the assembly of conductors (39) in a manner such that one of the first free ends (40) of each of said conductors falls directly over a connection terminal (42) of the chip and that each of the second free ends (41) of each of said conductors falls directly over a corresponding second hole (38) of the second unit, introducing the front face (11) of said chip into said rectangular opening from below the second substrate, soldering the chip terminals onto said first free ends of said conductors and coating with glue either the face of the second unit bearing the conductors or the back face of the first unit,

- applying the first unit (5) to the second unit (35) so that the holes of said first unit are turned towards the conductors borne by the second unit, and
- introducing the second free ends (41) of the conductors of the second unit into the respective holes (8) of the first unit by pushing said second free ends into said holes by means of a tool one introduces into the respective holes (38) of the second unit, and soldering said ends to the corresponding electrodes borne by said first unit.

2. Method according to claim 1, characterized by the fact that the first unit (5) is fabricated by the successive operations of : obtaining the first insulating substrate (6, 20), coating the first substrate with an adhesive material, perforating the first substrate with holes (8) corresponding in number to the electrodes (7) borne by said first unit when its fabrication is complete, applying a metallic leaf (21) onto said adhesive material and chemically engraving said electrodes in said leaf so that each overlays one of said holes.

3. Method according to claim 1, characterized by the fact that the first unit is fabricated by the successive operations of : obtaining the first insulating substrate (28), coating the first substrate with an adhesive material (22), perforating the first substrate with holes (8) corresponding in number to the electrodes (7) borne by said first unit when its fabrication is complete, obtaining a metallic leaf (25), forming the electrodes in said leaf by stamping or by chemical engraving, each of said electrodes remaining attached to the leaf by a bridge (27) so as to maintain an assembly, applying said leaf to said adhesive material covering said first substrate so that each of the electrodes overlays one of said holes and stamping the thus formed assembly and at the same time severing said bridges thus to obtain said first unit.

4. Method according to claim 1, characterized by the fact that at least a free space (43) formed between the peripheral edge of the chip (10) and the rectangular opening (37) into which it is introduced as well as between the conductors (39) and the front face (11) of the chip is filled with a compound (45) serving to rigidify the assembly of the chip, the second substrate and the conductors.

5. Method according to claim 1, characterized by the fact that the first and second units are mass produced on films (20, 28, 36) and following termination are cut away from their respective films.

6. Method according to claim 1, characterized by the fact that the first and second units are mass produced on films (20, 28, 36) and following termination the first unit (5) is cut away from its film then applied to the second unit (35), this latter remaining attached to its film (36) whereby the finished product is delivered in strips.

7. Method according to claim 1, characterized by the fact that said second holes (38) are arranged in two parallel rows, said chip (10) being situated in the space between said rows.

8. Method according to claim 7, characterized by the fact that the first unit (5) exhibits a surface and contour corresponding to the surface and contour of the second unit (35) so that upon superposition said units are edge to edge.

9. Method according to claim 7, characterized by the fact that the first (5) and second (35) units exhibit a similar contour, the surface of the first unit being smaller than that of the second unit so that following superposition of the first unit onto the second unit the contour of the first unit is inset from the contour of the second unit.

10. Method according to claim 1, characterized by the fact that said second holes (8) are arranged in two parallel rows, said chip (10) being situated outside the space between said rows.

11. Method according to claim 10, characterized by the fact that the surface of the first unit (5) is smaller than the surface of the second unit (35) whereby following superposition of said units the contour of the first unit is inset from the contour of the second unit and the chip is not covered by said first unit.

**Patentansprüche**

1. Verfahren zum Herstellen eines elektronischen Moduls (1) einer Karte mit Mikroschaltkreisen (2), wobei dieses Modul mehrere Elektroden (7), die dazu bestimmt sind, mit einer Vorrichtung, in welcher die Karte eingeführt wird, in Kontakt zu kommen, wenigstens einen Chip mit einer integrierten Schaltung (10), der eine vordere Seite (11), die mit Verbindungsanschlüssen (42) versehen ist, und eine Hinterseite (12) aufweist, und eine Leiteranordnung besitzt, welche die Elektroden mit den Verbindungsanschlüssen des Chip verbinden, umfassend die folgenden Stufen:

   - man stellt eine erste Einheit (5) her, die einen ersten Isolierträger (6, 20, 28) besitzt, der die Vielzahl von Elektroden (7) trägt, wobei jede Elektrode ein in diesem ersten Träger hergestelltes Loch abdeckt,

   - man stellt eine zweite Einheit (35) her, wobei man die folgenden Arbeitsschritte ausführt: man nimmt den Chip mit der integrierten Schaltung und einen zweiten Isolierträger (36), man beschichtet den zweiten Träger mit Klebstoff (47), man stellt im zweiten Träger eine rechteckige Öffnung (37) her, deren Abmessungen etwas größer sind als die Umfangsabmessungen des Chip, man erzeugt im zweiten Träger eine Anzahl zweiter Löcher (38), die der Anzahl der ersten Löcher (8), die in der ersten Einheit erzeugt worden sind, entspricht, wobei diese zweiten Löcher so angeordnet sind, daß sie mit den ersten im wesentlichen koaxial sind, wenn die erste und zweite Einheit übereinandergelegt sind, man bringt eine Metallfolie (48) auf die Klebschicht (47) auf, man ätzt die Folie chemisch, um die Leiteranordnung (39) so zu bilden, daß eines der ersten freien Enden (40) jedes Leiters über einer der Anschlußklemmen (42) des Chip zu liegen kommt und daß jeder der zweiten freien Enden (41) von jedem der genannten Leiter über einen zweiten, der zweiten Einheit entsprechenden Loch (38) zu liegen kommt, man führt die Vorderseite (11) des Chip von unten des zweiten Trägers in die rechteckförmige Öffnung ein, man lötet den Chip an den ersten freien Enden der Leiter an und man bedeckt entweder die Seite der zweiten Einheit, welche die Leiter trägt, oder die Hinterseite der ersten Einheit mit Kleber,

   - man bringt die erste Einheit (5) auf die zweite Einheit (35) auf, wobei die Löcher der ersten Einheit gegen die Leiter, die von der zweiten getragen werden, hinweisen,

   - man führt die zweiten freien Enden (41) der Leiter der zweiten Einheit in die jeweiligen Löcher (8) der ersten Einheit ein, indem man sie mit Hilfe eines Werkzeuges, das man in die jeweiligen Löcher (38) der zweiten Einheit einführt, hineinschiebt, und man lötet die Enden an die entsprechenden Elektroden, die von der ersten Einheit getragen werden, an.

2. Verfahren nach Anspruch 1, dadurch gekennzeichnet, daß die erste Einheit (5) hergestellt wird, indem man die folgenden Arbeitsschritte ausführt: man nimmt den ersten Isolierträger (6, 20), man beschichtet den ersten Träger mit einem Klebstoff, man erzeugt im ersten Träger eine Anzahl Löcher (8), die der Anzahl der Elektroden (7) entspricht, die von der ersten Einheit am Ende ihrer Herstellung getragen werden, man bringt eine Metallfolie (21) auf den Klebstoff auf und man ätzt die Elektroden chemisch, wobei letztere jeweils eines der genannten Löcher bedecken.

3. Verfahren nach Anspruch 1, dadurch gekennzeichnet, daß die erste Einheit hergestellt wird, indem man die folgenden Arbeitsschritte ausführt: man nimmt den ersten Isolierträger (28), man beschichtet den ersten Träger mit einem Klebstoff (22), man erzeugt im ersten Träger eine Anzahl Löcher (8), die der Anzahl der Elektroden (7) entspricht, die von der ersten Einheit am Ende ihrer Herstellung getragen werden, man nimmt eine Metallfolie (25), man bildet die Elektroden durch Stanzen oder durch chemisches Ätzen, wobei jede Elektrode mit der Folie über einen Steg (27) verbunden bleibt, um das Ganze zusammenzuhalten, man bringt die Folie auf den Klebstoff auf, der das erste Substrat bedeckt, wobei jede der Elektroden eines der Löcher bedeckt, und man stanzt die so gebildete Anordnung, indem man gleichzeitig die Stege durchtrennt, um so die erste Einheit zu erhalten.

4. Verfahren nach Anspruch 1, dadurch gekennzeichnet, daß wenigstens ein Freiraum (43), der zwischen dem Umfangsrand des Chip (10) und der rechteckigen Öffnung (37) gebildet ist, in die dieser eingeführt wird, und zwischen den Leitern (39) und der Vorderseite (11) des Chip mit einer Masse (45) ausgefüllt wird, um den Chip, den zweiten Träger und die Leiter zusammen zu verstärken.

5. Verfahren nach Anspruch 1, dadurch gekennzeichnet, daß die erste und die zweite Einheit in großen Serien auf Filmen (20, 28, 36) hergestellt werden, und daß sie, sobald sie fertiggestellt sind, von ihren jeweiligen Filmen abgeschnitten werden.

6. Verfahren nach Anspruch 1, dadurch gekennzeichnet, daß die erste und die zweite Einheit in großen Serien auf Filmen (20, 28, 36) hergestellt werden und daß die erste Einheit (5), sobald sie hergestellt ist, von ihrem Film abgeschnitten wird, dann auf die zweite Einheit (35) aufgebracht wird, welch letztere an ihrem Film (36) befestigt bleibt, wobei das Endprodukt als Band geliefert wird.

7. Verfahren nach Anspruch 1, dadurch gekennzeichnet, daß die zweiten Löcher (38) in zwei parallelen Reihen angeordnet sind, wobei der Chip (10) im Raum zwischen diesen Reihen angeordnet wird.

8. Verfahren nach Anspruch 7, dadurch gekennzeichnet, daß die erste Einheit (5) eine Oberfläche und eine Umrißform gleich der Oberfläche und der Umrißform der zweiten Einheit (35) besitzt, derart, daß sich die Einheiten Rand an Rand befinden, wenn sie einmal übereinandergelegt sind.

9. Verfahren nach Anspruch 7, dadurch gekennzeichnet, daß die erste (5) und die zweite (35) Einheit eine ähnliche Umrißform besitzen, wobei die Fläche der ersten kleiner ist als die Fläche der zweiten, derart, daß die Umrißlinie der ersten gegenüber der Umrißlinie der zweiten rückversetzt ist, wenn die erste Einheit einmal auf die zweite Einheit gelegt worden ist.

10. Verfahren nach Anspruch 1, dadurch gekennzeichnet, daß die zweiten Löcher (8) in zwei parallelen Reihen angeordnet sind, wobei der Chip (10) außerhalb des Raumes zwischen den genannten Reihen angeordnet wird.

11. Verfahren nach Anspruch 10, dadurch gekennzeichnet, daß die Fläche der ersten Einheit (5) kleiner ist als die Fläche der zweiten Einheit (35), derart, daß die Umrißkante der ersten gegenüber der Umrißkante der zweiten rückversetzt ist, sobald die Einheiten übereinandergelegt worden sind, so daß der Chip von der ersten Einheit nicht abgedeckt ist.

*Fig. 1*

*Fig. 4 a*

*Fig. 4 b*

*Fig. 4 c*

*Fig. 3a*

*Fig. 3 b*

*Fig. 2 d*

12

Fig. 2 a

Fig. 2 b

Fig. 2 c

Fig. 6a

Fig. 6b

Fig. 5

Fig. 7a        Fig. 7b        Fig. 7c

Fig. 8